# EUROPEAN PATENT APPLICATION

(11) **EP 4 365 506 A1**
(43) Date of publication of application: **08.05.2024**
(21) Application number: 23206810.6
(22) Date of filing: 30.10.2023
(51) Int. Cl.: F24F 13/08, H05K 5/02, H05K 7/20, E04D 13/17, F24F 13/20

(54) **VENTILATION APPARATUS**

(30) Priority: 04.11.2022 GB 202216442
(71) Applicant: Dense Air Limited, Marlow Buckinghamshire SL7 1EY (GB)
(72) Inventor: BAKER, David, Bristol, BS1 5BU (GB); LE MENTEC, Laurent, Bristol, BS1 5BU (GB); HADLEY, James Robert, Bristol, BS1 5BU (GB); COOMBS, Isabella Sapphire Colston, Bristol, BS1 5BU (GB)
(74) Representative: D Young & Co LLP

(57) **Abstract**

An apparatus for obstructing the passage of debris and providing ventilation through a region between a first object and a second object, the apparatus comprising: a body; and a plurality of tines extending from the body, wherein the tines are arranged in use such that when the body is connected to the first object, the tines extend across the region and flex against the second object leaving channels between the tines in the region allowing for ventilation.

## Description

### FIELD AND BACKGROUND

The present techniques relate to obstructing the passage of debris and providing ventilation through a region between two objects. More particularly, but not exclusively, the present techniques relate to an apparatus having a body and a plurality of tines for obstructing debris and providing ventilation through the region.

When two objects are spaced so as to define a region therebetween, it can be undesirable for debris to pass through the region. This may be particularly undesirable in scenarios where the objects are located outdoors and therefore exposed to weather and external conditions. Indeed, in some cases where one or both objects comprise electronic circuitry, the ingress or passage of debris can be particularly undesirable for electronic components as the debris can damage and interfere with the circuitry and components.

The inventors of the present techniques have identified that there is a balance between preventing the passage of debris through the region between objects, while still providing ventilation through the region, for example for allowing the passage of air and the cooling of electrical components of the electrical installation.

Known approaches include providing a plurality of brushes in the region, to catch debris and prevent its passage through the region, while not completely blocking the region. However, the present inventors have identified that such approaches provide unpredictable deformation of the brushes when installed, and thus unpredictable ventilation characteristics, which are undesirable for installations with electrical components. Further, due to the brushes and the unpredictable deformation when installed, some hairs of the brush may be deformed so as to encourage the ingress or passage of liquids though the region. For example, if hairs of the brush are deformed to slope towards the ground, water droplets may run along the hairs under the action of gravity and be encouraged to pass through the region. Furthermore, brushes may require a high insertion force during installation.

Other known approaches include providing a rigid sealing member for the region, which comprises a number of ventilation slits. While the ventilation characteristics may be more predictable than for brushes, the present inventors have identified that this approach may not be able to accommodate a range of differently size regions. In particular, bespoke sealing members are required that are specific to the region and the objects that define the region.

At least certain embodiments of the present disclosure address one or more of these problems as set out above.

### SUMMARY

The invention is defined in the appended claims.

Viewed from a first aspect, there is provided an apparatus for obstructing the passage of debris and providing ventilation through a region between a first object and a second object, the apparatus comprising: a body; and a plurality of tines extending from the body, wherein the tines are arranged in use such that when the body is connected to the first object, the tines extend across the region and flex against the second object leaving channels between the tines in the region allowing for ventilation.

In other words, in use, the tines extend across the region between the two objects and flex against the second object. The tines therefore act so as to obstruct the passage of debris through the region by catching debris on and between the tines, thus stopping the debris. The tines are also arranged to leave channels between the tines such that passage of air through the region is possible. In this way, the present approach provides an apparatus that can efficiently and effectively obstruct debris from passing through a region between two objects, while still allowing for ventilation through the region. Furthermore, this may be achieved in a predictable manner. The use of tines may also enable a lower insertion force during installation to be used, when compared to examples involving brushes rather than tines.

Viewed from a second aspect, there is provided a method for obstructing the passage of debris and providing ventilation through a region between a first object and a second object, the method comprising: connecting one or more apparatuses according to the first aspect to the first object; and attaching the first object to the second object to define the region, such that the tines of the one or more apparatuses extend across the region and flex against the second object leaving channels between tines in the region allowing for ventilation.

In other words, the apparatus is connected to the first object, and the first object is attached to the second object, leaving a gap therebetween defining a region, such that the tines extend across the region and flex against the second object. Thus, debris may be obstructed from passing through the region while still providing ventilation through the region.

Other aspects will also become apparent upon review of the present disclosure, in particular upon review of the Brief Description of the Drawings, Detailed Description and Claims sections.

### BRIEF DESCRIPTION OF THE DRAWINGS

Examples of the disclosure will now be described, by way of example only, with reference to the accompanying drawings in which:
Figure 1: schematically illustrates a) an apparatus according to the present techniques, and b) an apparatus according to the present techniques when in use.
Figure 2: schematically illustrates in different views how tines of the apparatus may flex in use.
Figure 3: schematically illustrates example apparatuses according to the present techniques.
Figure 4: schematically illustrates example tine arrangements according to the present techniques.
Figure 5: schematically illustrates a further example apparatus according to the present techniques.
Figure 6: schematically illustrates a further example apparatus according to the present techniques.
Figure 7: schematically illustrates a further example apparatus according to the present techniques.
Figure 8: schematically illustrates a further example apparatus according to the present techniques.
Figure 9: schematically illustrates a further example apparatus in use.
Figure 10: schematically illustrates a perspective view of a portion of an example apparatus.
Figure 11: schematically illustrates a further example apparatus according to the present techniques.
Figure 12: schematically illustrates a further example apparatus according to the present techniques.
Figure 13: schematically illustrates an example method according to the present techniques.

While the disclosure is susceptible to various modifications and alternative forms, specific example approaches are shown by way of example in the drawings and are herein described in detail. It should be understood however that the drawings and detailed description attached hereto are not intended to limit the disclosure to the particular form disclosed but rather the disclosure is to cover all modifications, equivalents and alternatives falling within the spirit and scope of the claimed invention.

It will be recognised that the features of the above-described examples of the disclosure can conveniently and interchangeably be used in any suitable combination.

### DETAILED DESCRIPTION

As discussed herein, the present techniques obstruct the passage of debris and provide ventilation through a region or gap between a first and second object. The present techniques provide improved debris obstruction and more predictable and reliable ventilation performance compared to comparative examples that do not utilise tines. Further, the present approach is reusable as the tines flex, in that parts need not be snapped off, or otherwise modified, during installation to ensure fit to the second object. The tines also may flex independently, such that they conform to different surfaces, for example non-uniform surfaces and different shapes. This results in a more flexible approach that may be used with a greater variety of objects.

In some examples, in use, flexing of the tines is substantially constrained to a plane. Thus, in these examples, the flexing of the tines is more predictable and so the configuration of the apparatus and the tines may be optimised for certain use cases. Moreover, flexing in this manner provides a more optimal channel configuration to allow for ventilation in the region. This also has the benefit of providing a more regular obstruction effect for debris that may impinge on the tines. Further, constraining flexing of the tines substantially to a plane reduces the likelihood that the tines will be damaged when in use and flexed against the second object.

In some examples, elongate axes of the plurality of tines define the plane. Thus, the tines may be substantially constrained to flex in a plane defined by the long axes of the tines, i.e. the axes of the extension of the tines from the body. In other words, in use, flexing is substantially prevented from occurring in the perpendicular z-axis. Thus, tines are prevented from deforming to slope towards the ground in use when the z-axis is in the vertical direction, and so water droplets are prevented from running along the tines under the action of gravity and are not encouraged to pass through the region.

In these examples, the flexing of the tines is more predictable and thus ventilation and debris obstruction characteristics may be optimised for certain uses. Further, the effectiveness of the debris obstruction is increased because the tines substantially all flex in the same plane and flex against the second object in use in a more resilient manner, as the tines are not angled diagonally against the second object for example. Thus, the debris obstruction characteristic of this arrangement is increased. Moreover, the ventilation channels may be more uniform to allow for more uniform airflow and passage of air through the region. Further, damage to the tines is reduced as over flexing caused by flexing in three dimensions may be prevented.

In some examples, in use, each tine of the plurality of tines flexes in a predetermined direction. In some examples, the predetermined direction that each tine flexes in may be different, in other examples, a subset of the plurality of tines may flex in substantially the same direction. Thus, again, deformation of the tines is more predictable, and thus so is the debris obstruction and ventilation characteristics. Accordingly, an apparatus designed for a specific use case or combination of first and second objects may be more performant and/or optimised for that use case.

In some examples, the body is arcuate and the tines extend inwardly from the inner circumference of the body. In other words, the body may be curved and the tines may all extend from the same side of the body and from an inner circumference of the curved body. In these examples, the body may be particularly suited for certain use cases, for example where one or both of the first and second object have arcuate or curved surfaces that define the region. In some examples, the body is substantially semi-circular. In this example, the tines extend from the inner surface of the curve.

In other examples, the body may be wavy or flat, and the tines may extend from a wavy or flat surface of the body. For example, in cases where one or both of the first and second object have wavy or flat surfaces that define the region, the wavy or flat body may be particularly well suited for obstructing debris while allowing for ventilation.

In some examples, the tines are angled acutely with respect to the body. In other words, the tines are not angled perpendicular to the body. This encourages the flexing of the tines, rather than buckling or snapping of the tines against the second object in use. Further, the angle(s) may be such that the tines are encouraged to flex in their respective predetermined directions, improving the predictability of the deformation and the related debris obstruction and ventilation characteristics.

In some examples, the plurality of tines comprises tines of different lengths. Thus, the tines may have lengths selected for certain use cases and certain configurations of first and second objects, for example to extend across a non-uniform region, or a region with a changing distance between the first and second object. Thus, even with these variations, debris obstruction while allowing for ventilation may still be achieved.

In some examples, lengths of the tines increase towards a central region of the body. The present inventors have identified that different length tines provide improved flexing performance, and improved uniformity in flexing. In some examples, lengths of the tines decrease towards a central region of the body. In this arrangement, tines are sized in the central region so as not to interfere with each other.

In other examples, one or more tines extending from a region of the body distal from the centre of the body have a length shorter than tines extending from a non-distal region. In other words, tines at the centre of the body are longer than tines away from the centre. In these examples, the central tines may therefore flex to a greater amount against the second object, providing a more resilient barrier to obstruct debris.

In other examples, one or more tines extending from a region of the body distal from the centre of the body have a length longer than tines extending from a non-distal region. In other words, tines not at the centre of the body are longer. In use, when the tines flex against the second object, longer peripheral tines may advantageously be more likely to flex against the second object rather than buckle and snap.

In some examples, one or more tines of the plurality of tines comprise portions angled differently with respect to the body from which the one or more tines extend. In other words, one or more tines may have a kink or bend in them, such that the tines are not straight. This may increase the flexing likelihood, and increase the predictability of how the tine is likely to flex when contacting the second object. Forming the tines in this manner also increases the resilience of the vanes as they are predisposed to flexing in a certain direction.

In some examples, the plurality of tines comprises tines angled differently with respect to the body. In other words, different tines may be angled differently from the body. In this way, the spatial configuration of the tines can be optimised for certain use cases. Indeed, in certain implementations, angling the tines differently to one another can encourage flexing, and can ensure that tines do not obstruct the second object in use. Indeed, such angling can also help to prevent tines from flexing in three dimensions.

In some examples where the body is arcuate or substantially semi-circular, the tines may be angled towards a central region of the curve or semicircle. This arrangement encourages flexing into the semi-circle, and thus in use when the tines are brought into contact with the second object, they flex against it by a push-fit of the body towards the second object.

In some examples, the angle of the tines with respect to the body increases towards a central region of the body. In other words, the tines are more acutely angled from the body in a central region of the body. In examples where the body is arcuate or substantially semi-circular, this angled configuration helps to prevent central vanes from interfering with the second object in an undesirable way, for example, by snapping or being misaligned with other neighbouring tines.

In some examples, the plurality of tines is arranged into at least a first tine group and a second tine group, each tine group comprising a plurality of tines, the tine groups being separated by a tine-free region. Thus, the two tine groups are separated by a region without tines, thereby allowing for tines that neighbour the tine-free region to flex into the region. This may be especially preferable in examples where the body is arcuate or substantially semi-circular, and the tines are angled towards a central point of the curve or semicircle, to allow space for the central tines to flex.

In some examples, the separation of the first and second tine groups defined by the tine-free region is at least double the maximum spacing between adjacent tines in the first or second tine groups. The present inventors have identified that such a spacing allows room for the most proximal tines to flex into the space, while still obstructing debris and allowing for ventilation.

In some examples, the tine-free region comprises a barrier extending from the body to an extension length at most half the length of the extension length of the tine with the maximum extension length. In other words, the tine-free region may instead comprise a barrier, for example a protruding region, rather than tines. This barrier may provide debris obstruction in the tine-free region. This barrier may also be sized so as to indicate to an installer of the apparatus the point at which the body and tines are spaced appropriately from the second object. In other words, the installer may in use push the body against the second object, thus causing the tines to flex, until the barrier abuts the second object. This therefore indicates to the installer that the body has been located correctly, with an expected level of flexing. The size of the barrier may be optimised for the specific use case and desired level of flex of the tines (and thus the tine spacing, and debris obstruction and ventilation characteristics).

In some examples, the plurality of tines is arranged into at least a first tine group and a second tine group, each tine group comprising a plurality of tines, the tine groups being separated by a region comprising tines of a length shorter than the minimum tine length of tines in the first or second tine groups. Alternatively, or additionally, to the barrier, the two tine groups may be separated by a region of comparatively shorter vanes. This may provide an advantageous alternative to the lack of tines in a tine-free region, as shorter tines may still be able to obstruct from the passage of debris.

In some examples, the body comprises a first body and second body, each body having a plurality of the tines. Thus, in this example, the apparatus comprises multiple bodies. The bodies may be configured to complement each other, for example to interface and/or otherwise connect with each other. In this way, attachment of the bodies to the first object may be simplified. Further, one of the bodies may be replaced independently, for example in the event of damage.

In some examples, in use, the first body and second body substantially surround the second object. Thus, during installation, the first body and second body may be brought into connection around the second object, and secured to the first object. The present inventors have identified that providing multiple bodies simplifies installation where the second object is surrounded by the two bodies, for example where the second body is a post or pole. Further, surrounding the second object in this manner ensures effective debris obstruction is provided around the second object.

In some examples, a ratio of tine length to spacing between adjacent tines is in the range 2.5 to 20 in an example, 3.5 to 20 in one example, and 2.5 to 6 in another example. The present inventors have identified that this ratio provides particularly optimised debris obstruction and ventilation performance, and further provides adequate space between adjacent vanes to allow for the vanes to flex.

In some examples, a thickness of the tines and the body in a direction perpendicular to elongate axes of the plurality of tines is the same. In other words, the tines and body may have a substantially equal material thickness. For example, the body and tines may be injection moulded, laser cut from a sheet of thermoplastic, or cut by water jet out of a sheet of material.

In other examples, the tines and body have a different material thickness. In this way, material usage may be more efficient. In some examples, the body is substantially flat in two dimensions, whereas in others the body may have a wavy, curved, or otherwise non-uniform thickness. It will be appreciated that the exact configuration may be optimised for the intended use case.

In some examples, the second object is a post, and wherein optionally the post has a circular, oval, square, rectangular, hexagonal, or octagonal cross-section. Thus, the tines may extend across the region between the first object and the post and flex against the post. In some examples, the post is a lamppost, a post of a road sign, a post of a traffic light, or other street furniture. In these examples, in use, the apparatus may provide debris obstruction and ventilation between the first object and a post that is outside and exposed to weather conditions and general detritus.

Further, due to the flexing of the tines against the post, the apparatus may be capable of providing debris obstruction and ventilation when the post has a variety of cross-sectional shapes, for example hexagonal, octagonal or other non-circular shapes. In these examples, the length and angle profiles of the tines may be adapted to ensure the tines flex against the outer surface of the post.

In some examples, the second object comprises a third object on its surface, such that the tines flex against the second object and the third object. As an example, the second object may be a post, and the third object may be a cable or cable conduit. In this way, despite the cable or cable conduit or other third object being located on the surface of the second object (or post), the tines are nonetheless able to account for this lack of uniformity and flex differently against both the second and third object. For example, if a cable conduit disrupts the surface profile of the post and protrudes into the region between the first object and the post, the tines may flex against the cable conduit to a greater extent than against the post, due to the cable conduit being more proximal to the body than the post. Despite the non-uniform surface profile of the second object, the apparatus is still able to obstruct debris and provide ventilation. In other words, the tines flex and conform to the outer profile of the second object (and other additional objects thereon).

In some examples, the first object comprises electronic circuitry. In these examples, ventilation, and adequate and predictable ventilation, may be particularly important for preventing the overheating of electronic circuitry comprised within the first object. Passage through the region between the first and second object may lead to an internal volume of the first object, where electronic circuitry may be located. Debris passing through the region and into this internal volume may damage and interfere with the electronic circuitry. As a result of the present approach, debris may be obstructed from interfering with the electronic circuitry of the first object, while still allowing for ventilation (i.e. circulation of air and passage of air through the region).

Further, in examples where the first object, second object, and apparatus are installed outside, the specific flexing arrangement of the tines may reduce the likelihood of water ingress through the region, as the vanes may not be angled in a diagonal vertical direction. This prevents water impinging on the vanes running down the vanes under the action of gravity and passing through the region, potentially to an internal volume of the first object. It will be appreciated, that the apparatus may be installed in a variety of orientations and locations that will vary depending on implementation.

In some examples, the first object is a wireless communication module, and optionally wherein the first object is a 4G or 5G communication module. The apparatus may therefore be connected to a wireless communication module and used to obstruct debris from passing through a region between the wireless communication module and a second object, for example, a post on which it is installed, while providing ventilation.

In an example, the wireless communication module is installed around a post, such that the module surrounds the post, and after installation, the post passes through a through-hole formed in the module. In this example, the apparatus may be installed to provide debris obstruction and ventilation in the gap between the module and the post.

As mentioned, the first object may be a 4G or 5G communication module. Such modules may contain sensitive electronic circuity, such that debris protection is important, while still being able to evacuate hot air through the ventilation channels formed by the tines.

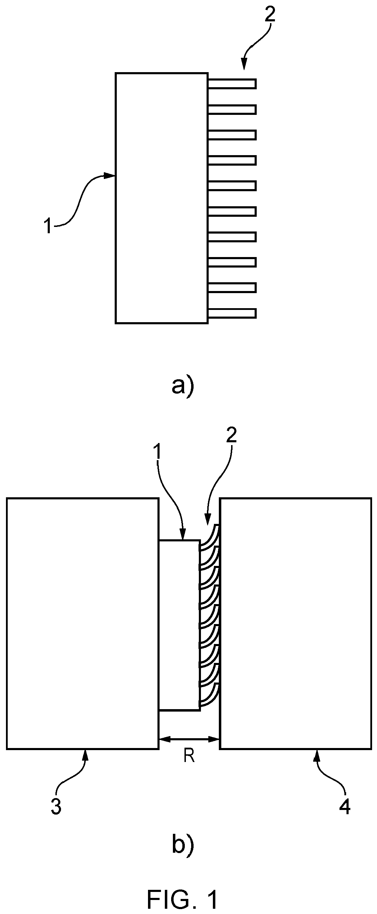

Figure 1 schematically illustrates a) an apparatus according to the present techniques, and b) an apparatus according to the present techniques when in use.

As shown in figures 1a and 1b, the apparatus comprises a body 1 and a plurality of tines 2 extending from the body. While the body 1 is shown as being rectangular in plan view, it will be appreciated that the body 1 may be a variety of shapes, depending on the implementation. Similarly, the number of tines in the plurality of tines 2 and their configuration may also vary depending on implementation.

As shown, an end of each tine is attached to the body 1, and the tines 2 are elongate, each extending in an elongate axis/direction. The tines 2 are flexible and thus the dimension and material may be chosen accordingly, and may be chosen for the specific use case. For example, the body and/or the tines may be made from plastic, rubber, metal, wood or composites.

In use, as shown in figure 1b, a first object 3 and a second object 4 define a region R therebetween. Without the present techniques, debris may pass through this region R. In use, the body 1 is connected to the first object 3, and the tines 2 extend across the region R and flex against the second object 4. Thus, the tines 2 obstruct the passage of debris through the region R. In use, the flexing of the tines 2 leaves channels between the tines 2 in the region R to allow for ventilation. It will be appreciated that the body 1 and the first object 3 may connect in a variety of ways, and the body 1 may not protrude into the region R. For example, body 1 and first objection 3 may be connected by use of adhesive, bolt(s), screw(s) and/or an interference fit.

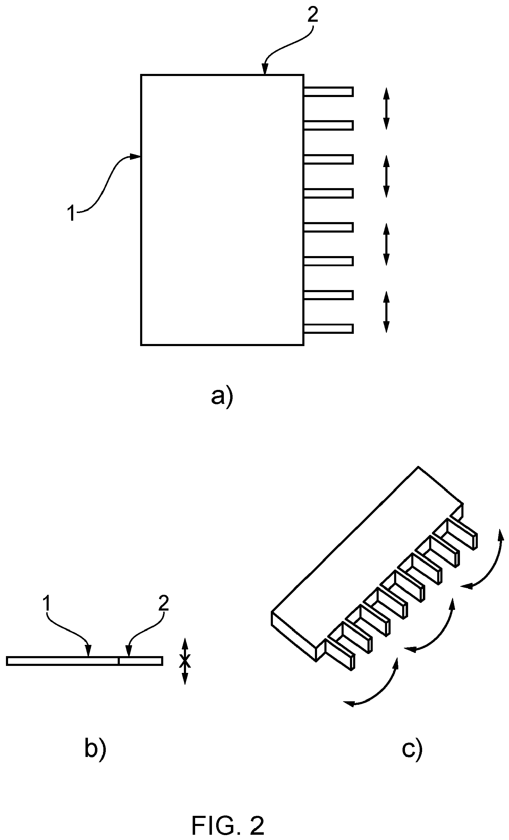

Figure 2 schematically illustrates how tines of the apparatus may flex in use in different views. In plan view, figure 2a, flexing of the tines 2 is substantially constrained to a plane. As shown, the plane is defined by elongate axes of the tines 2. In other words, with reference to figure 2a, the plane of the elongate axes of the tines may be considered a plane in the x - y-axis, such that there is substantially no flexing of the tines in the z-axis. In use, the tines may flex in a plane parallel to the ground, with substantially no flexing a vertical direction (i.e. in cases where the z-axis is orientated in the vertical directions). In this figure the double-headed arrows depict the flexing direction in the plane. While there may be a minor amount of flexing in a direction not defined by the plane, substantially constrained can, in some examples, be defined as meaning that the tines flex to less than 50% of their width in this direction, or that 90% of the flexing of the tines occurs in the plane defined by their elongate axes.

Figure 2b shows a side-on view of the body 1 and tines 2. The crossed-out double-headed arrow in this figure indicates the direction in which substantially no flexing occurs. As mentioned, it will be appreciated that negligible amount of flexing may occur in this direction, but that the majority of flexing occurs in the plane defined by elongate axes of the tines. Figure 2c shows a perspective view of the apparatus, with double-headed arrows to indicate the 'side-to-side' flexing of the tines, substantially without any 'up-and-down' flexing.

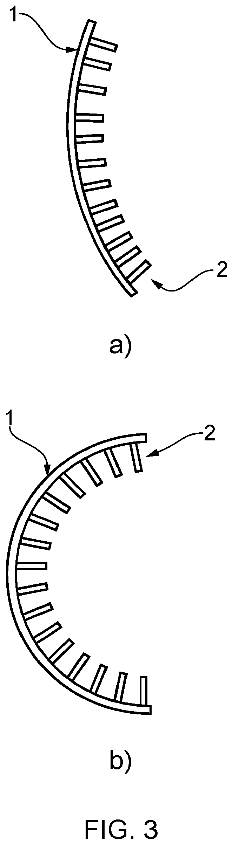

Figure 3 schematically illustrates example apparatuses according to the present techniques. As shown in figure 3a, the body 1 is arcuate, in that the body 1 is curved or non-linear. The tines 2 extend from an inner surface of the curve or circumference of the body 1. Figure 3b shows the body 1 as being substantially semi-circular, with the tines 2 extending from an inner surface of the curve. The apparatuses shown in figures 3a and 3b may be particularly well suited for obstructing debris and providing ventilation in a region bounded by a non-flat second object. The tines 2 may conform to the shape of the second object and flex against an outer surface thereof.

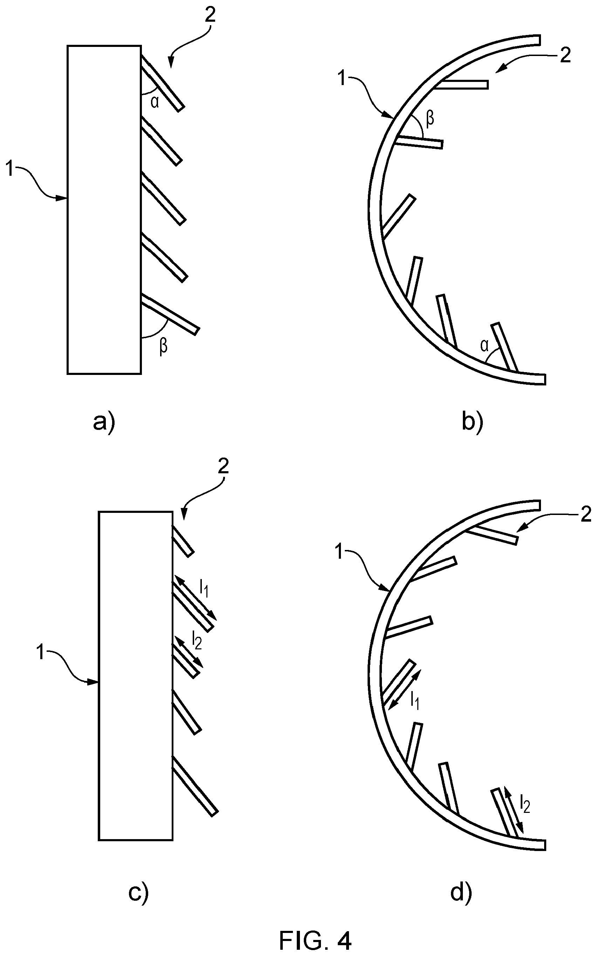

Figure 4 schematically illustrates example tine arrangements according to the present techniques. As shown in figures 4a and 4b, a tine of the tines 2 may have angle α when measured from a surface of the body, and another tine may have an angle β. As shown, the tines may be angled acutely with respect to the body. Thus, α and β may be less than 90 degrees. Angling the tines acutely with respect to the body (i.e. not perpendicular to the body), encourages flexing in a certain direction and thus a) reduces the likelihood of a tine snapping and breaking when brought into contact with a second object, and b) reduces the likelihood that the tines will significantly increase the force required to bring the second object/apparatus into the desired position during installation.

In some examples, the plurality of tines comprises tines angled differently with respect to the body. Thus, α and β may be different. The present inventors have identified that angling tines differently allows for custom debris obstruction and ventilation performance, and thus that the configuration of the tines may be chosen for a specific use case.

As shown in figures 4c and 4d, the tines may comprise tines of different lengths. Thus, I₁ and I₂, which define the elongate length of two of the tines, may be different. As discussed, the tines may have lengths for certain use cases and certain configurations of first and second objects, for example to extend across a non-uniform region, or a region with a changing distance between the first and second object.

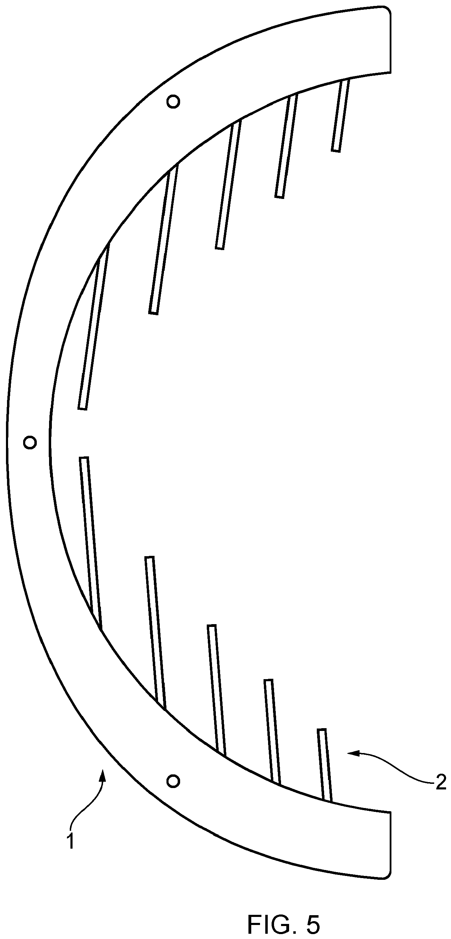

Figure 5 schematically illustrates an example apparatus according to the present techniques. As shown, the lengths of the tines 2 increase towards a central region of the body, and the angle of the tines 2 with respect to the body 1 decreases towards a central region of the body. In some use cases, this configuration may provide improved debris obstruction characteristics.

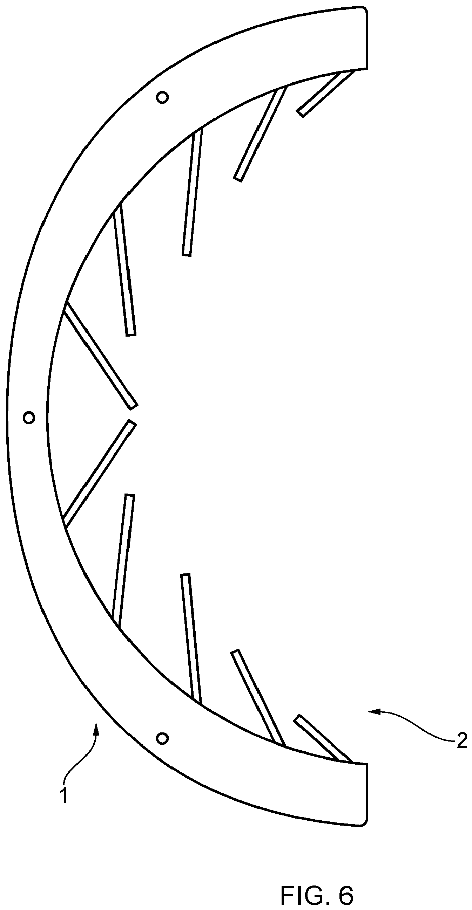

Figure 6 schematically illustrates an example apparatus according to the present techniques. As shown, the lengths of the tines 2 increase towards a central region of the body, and the angle of the tines 2 with respect to the body 1 increases towards a central region of the body. In some use cases, this configuration may provide improved debris obstruction characteristics.

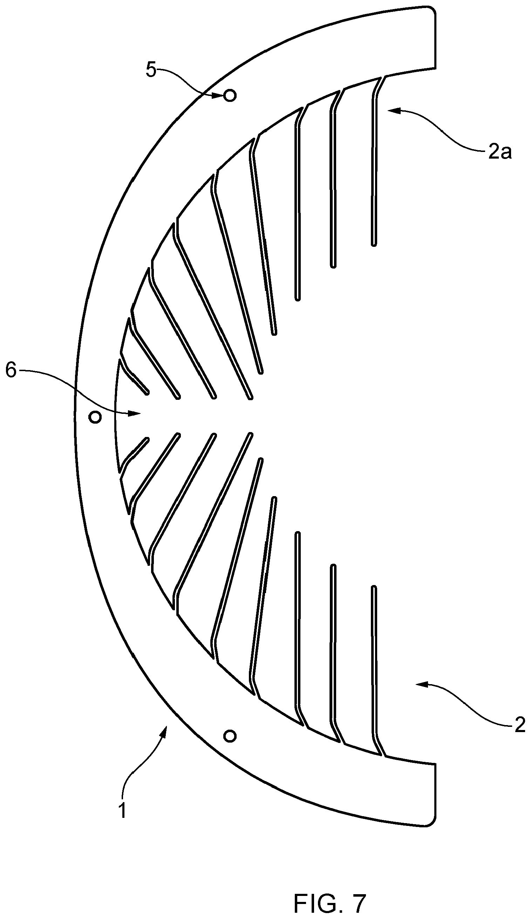

Figure 7 schematically illustrates a further example apparatus according to the present techniques. The apparatus comprises body 1 and tines 2. The tines 2 comprise portions angled differently with respect to the body. As shown in figure 7, elbow 2a causes tine 2 to comprise differently angled portions. Providing an elbow 2a encourages the tines to flex in a predetermined manner. Further, the elbow 2a causes the tines to flex along a more curved path than without the elbow, meaning that the tines span a greater amount of the region, thus improving debris obstruction performance.

The apparatus also comprises holes 5, which may act as a connection means for connecting the apparatus to the first object. Tine-free region 6 may separate a first group of vanes (the vanes above the region) from a second group of vanes (the vanes below the region). The tine-free region 6 may provide space for the tines neighbouring the region to flex without interfering with one another. The tine-free region 6 may be at least double the width of the maximum spacing between adjacent vanes in the first or second tine groups. This configuration has been found to provide space for the vanes to flex without interfering with one another.

As shown in figure 7, tines extending from a region of the body distal from the centre of the body have a length longer than tines extending from a central region. In some use cases, this arrangement may be beneficial.

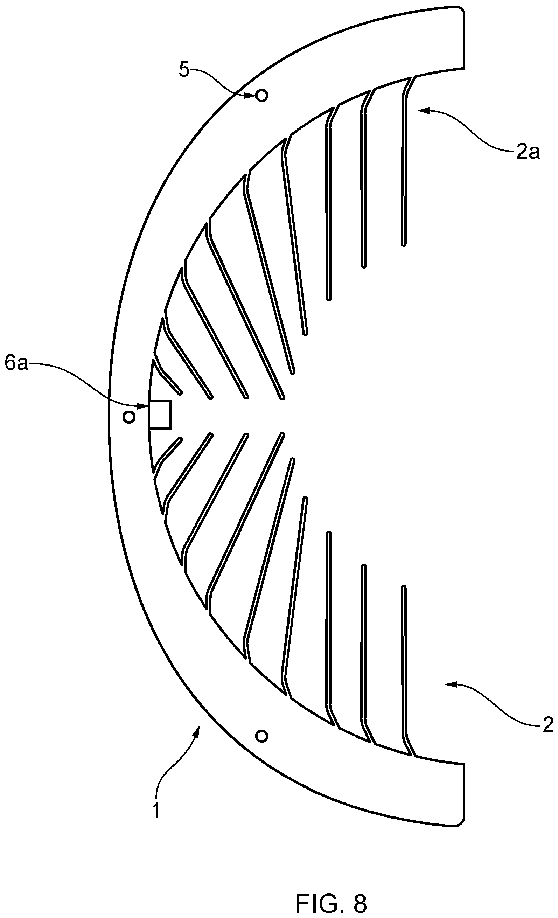

Figure 8 schematically illustrates a further example apparatus according to the present techniques. Here, a barrier 6a is present in the region between the two tine groups. As discussed above, this may act so as to provide additional debris obstruction, and may also serve as an indicator for an installer as to when the tines have been appropriately flexed against the second object.

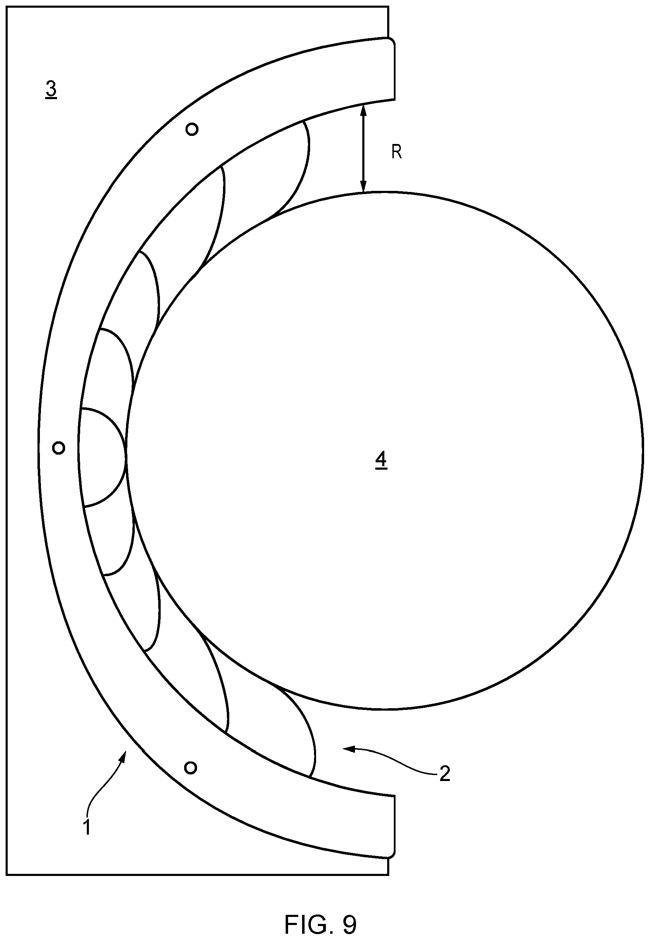

Figure 9 schematically illustrates an example apparatus in use. Body 1 is connected to first object 3. The second object 4 has a circular cross section in this example, although it will be appreciated that the present approach would work on various shaped cross-sections of the second object 4. The gap between the first object 3/the body 1 and the second object 4 defines the region R. The tines 2 flex against the outer surface of the second object 4, thus leaving channels for ventilation, while still being able to obstruct pieces of debris. The ratio of tine length to spacing between adjacent tines may be in the range 2.5 to 20, 3.5 to 20, or 2.5 to 6. The present inventors have identified that these ranges provide an effective balance between tine flexibility and debris obstruction. It will be appreciated that the spacing of the tines may be uniform or may vary, depending on implementation. As such an apparatus may be configured accordingly to provide desired debris obstruction and ventilation characteristics.

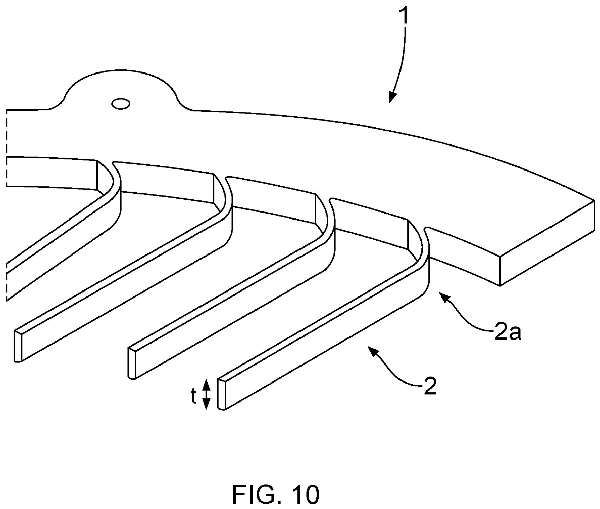

Figure 10 schematically illustrates a perspective view of a portion of an example apparatus. As shown, the thickness t of the tines and the body in a direction perpendicular to the elongate axes of the tines 2 is the same. In other words, a material thickness of the tines and body may be the same. In some examples, the thickness may be in the range of 4mm to 10mm, preferably 6mm or 9mm. The width of the tines, i.e. the width of the tines perpendicular to their thickness t may be in the range of 1mm to 2mm, and preferably 1.0mm, 1.25mm or 1.5mm.

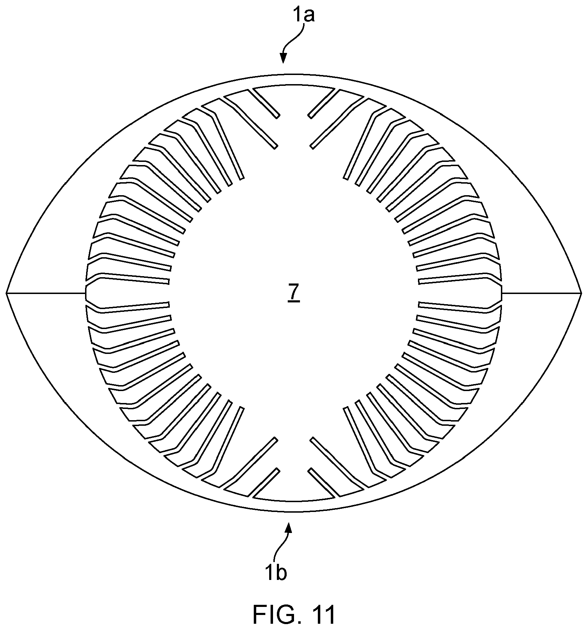

Figure 11 schematically illustrates an example apparatus according to the present techniques. As shown, body 1 comprises a first body 1a and a second body 1b. Each of bodies 1a and 1b comprise a plurality of tines. Bodies 1a and 1b complement each other and configured to interface with each other. In some examples, bodies 1a and 1b may be the same shape as each other. For example, as shown in figure 11, the bodies connect to define a central area 7. The second object (e.g. pole) may be within central area 7, such that the bodies 1a and 1b substantially surround the second object. In use, the tines from the two bodies 1a and 1b will extend from the bodies and flex against the surface of the second object located in the central area 7.

Central regions of each body 1a and 1b comprise tines without elbows. This allows the central tines to flex without interfering with one another. In some examples, the bodies are connected to the first object and the second object is a pole or post. In this example, the pole may penetrate the central region, and the bodies 1a and 1b may substantially surround the pole. A first set of bodies may be sized so as to accommodate poles with a diameter or 114 to 200mm, and a second set of bodies may be sized so as to accommodate poles with a diameter of 203mm to 220mm. It will be appreciated that the length of tines may be sized accordingly. In some examples, the maximum spacing between adjacent vanes is 20mm, where the spacing refers to the spacing along the body of the tines.

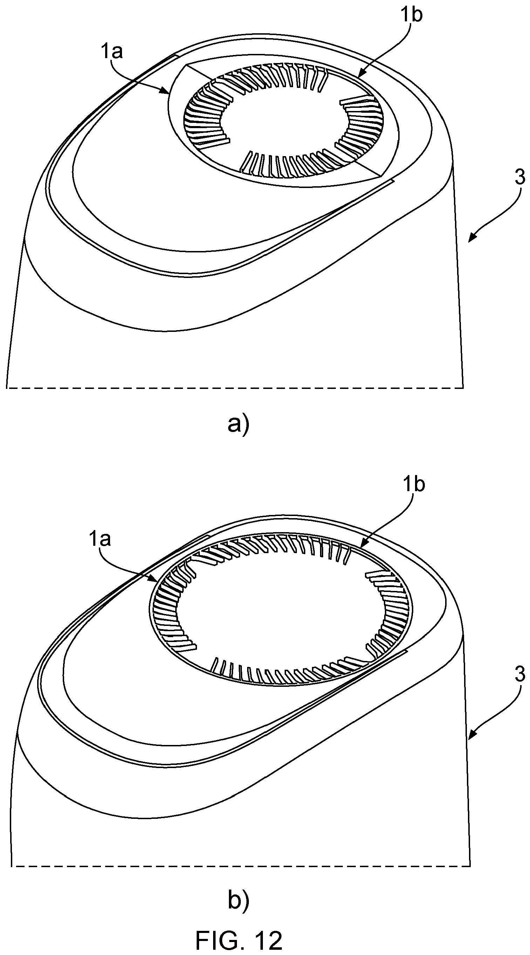

Like the apparatus of figure 11, the apparatuses of figure 12 comprise first and second bodies 1a and 1b. However, figure 12 illustrates the apparatuses when connected to example first objects 3. In this figure, the first object 3 is a casing or module. The module 3 may comprise electronic circuitry, and may be installed around a post or pole.

An example scenario will now be described. The module may be suitable for attaching to a pole. The module may be split into two parts for installation around a pole. Each body 1a and 1b may first be connected to the module, for example via screws or other fixing means. The first part of the module 3 may be placed adjacent a pole, and the second part of the module may be brought into abutment with the first half so as to surround the pole. In doing so, the tines of bodies 1a and 1b may thus extend across the region between the module and pole and flex against a surface of the pole.

With reference again to figure 12, the bodies 1a and 1b may be shaped so as to accommodate different second objects (e.g. poles). For example, the tines extending from bodies 1a and 1b in figure 12a define a smaller internal diameter than that defined in figure 12b. The size and shape of the body, and the size of the tines may be selected depending on the specific implementation (e.g. from a selection of a few different tine sizes that each cover a range of second object shapes and diameters). However, it should be appreciated that a single apparatus is able to accommodate a range of different shapes and sizes of the second object, due to the flexibility of the tines.

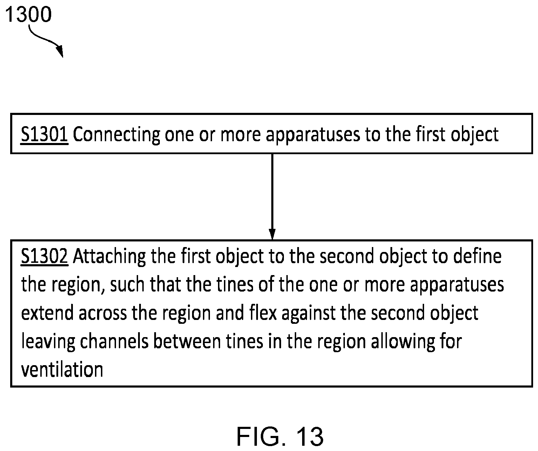

Figure 13 schematically illustrates a method 1300 for obstructing the passage of debris and providing ventilation through a region between a first object and a second object.

At S1301, one or more apparatuses are connected to the first object. For example, two apparatuses (one apparatus can be considered, for example, as the combination of body 1 and plurality of tines 2 depicted in figure 9) may be connected to the first object 3 as shown in figure 9. It will be appreciated, that method 1300 can also be applied to the apparatuses depicted in the other figures.

At S1302, the first object is attached to the second object (e.g. second object 4 depicted in figure 9) to define the region (e.g. region R depicted in figure 9), such that the tines of the one or more apparatuses extend across the region and flex against the second object leaving channels between tines in the region allowing for ventilation.

In this way, the passage of debris through the region between the first and second object may be obstructed, while still allowing for ventilation through the region.

The various embodiments described herein are presented only to assist in understanding and teaching the claimed features. These embodiments are provided as a representative sample of embodiments only, and are not exhaustive and/or exclusive. It is to be understood that advantages, embodiments, examples, functions, features, structures, and/or other aspects described herein are not to be considered limitations on the disclosure scope defined by the claims or limitations on equivalents to the claims, and that other embodiments may be utilised and modifications may be made without departing from the scope of the invention as defined by the claims.

### CLAUSES:

1. An apparatus for obstructing the passage of debris and providing ventilation through a region between a first object and a second object, the apparatus comprising:
   a body; and
   a plurality of tines extending from the body, wherein the tines are arranged in use such that when the body is connected to the first object, the tines extend across the region and flex against the second object leaving channels between the tines in the region allowing for ventilation.
2. The apparatus of clause 1, wherein, in use, flexing of the tines is substantially constrained to a plane.
3. The apparatus of clause 2, wherein elongate axes of the plurality of tines define the plane.
4. The apparatus of any preceding clause, wherein, in use, each tine of the plurality of tines flexes in a predetermined direction.
5. The apparatus of any preceding clause, wherein the body is arcuate and the tines extend inwardly from the inner circumference of the body, and optionally the body is substantially semi-circular.
6. The apparatus of any preceding clause, wherein the tines are angled acutely with respect to the body.
7. The apparatus of any preceding clause, wherein the plurality of tines comprises tines of different lengths.
8. The apparatus of any preceding clause, wherein lengths of the tines increase towards a central region of the body.
9. The apparatus of any preceding clause, wherein one or more tines extending from a region of the body distal from the centre of the body have a length shorter than tines extending from a non-distal region.
10. The apparatus of any of clauses 1 to 8, wherein one or more tines extending from a region of the body distal from the centre of the body have a length longer than tines extending from a non-distal region.
11. The apparatus of any preceding clause, wherein one or more tines of the plurality of tines comprise portions angled differently with respect to the body from which the one or more tines extend.
12. The apparatus of any preceding clause, wherein the plurality of tines comprises tines angled differently with respect to the body.
13. The apparatus of any preceding clause, wherein the angle of the tines with respect to the body increases towards a central region of the body.
14. The apparatus of any preceding clause, wherein the plurality of tines is arranged into at least a first tine group and a second tine group, each tine group comprising a plurality of tines, the tine groups being separated by a tine-free region.
15. The apparatus of clause 14, wherein the separation of the first and second tine groups defined by the tine-free region is at least double the maximum spacing between adjacent tines in the first or second tine groups.
16. The apparatus of clause 15, wherein the tine-free region comprises a barrier extending from the body to an extension length at most half the length of the extension length of the tine with the maximum extension length.
17. The apparatus of any of clauses 1 to 14, wherein the plurality of tines is arranged into at least a first tine group and a second tine group, each tine group comprising a plurality of tines, the tine groups being separated by a region comprising tines of a length shorter than the minimum tine length of tines in the first or second tine groups.
18. The apparatus of any preceding clause, wherein the body comprises a first body and a second body, each body having a plurality of the tines.
19. The apparatus of clause 18, wherein, in use, the first body and second body substantially surround the second object.
20. The apparatus of any preceding clause, wherein a ratio of tine length to spacing between adjacent tines is in the range 2.5 to 20.
21. The apparatus of any preceding clause, wherein a thickness of the tines and the body in a direction perpendicular to elongate axes of the plurality of tines is the same.
22. The apparatus of any preceding clause, wherein the second object is a post, and wherein optionally the post has a circular, oval, square, rectangular, hexagonal, or octagonal cross-section.
23. The apparatus of any preceding clause, wherein the first object comprises electronic circuitry.
24. The apparatus of any clause 23, wherein the first object is a wireless communication module, and optionally wherein the first object is a 4G or 5G communication module.
25. A method for obstructing the passage of debris and providing ventilation through a region between a first object and a second object, the method comprising:
   connecting one or more apparatuses according to any of clauses 1 to 24 to the first object; and
   attaching the first object to the second object to define the region, such that the tines of the one or more apparatuses extend across the region and flex against the second object leaving channels between tines in the region allowing for ventilation.

## Claims

1. An apparatus for obstructing the passage of debris and providing ventilation through a region between a first object and a second object, the apparatus comprising:
a body; and
a plurality of tines extending from the body, wherein the tines are arranged in use such that when the body is connected to the first object, the tines extend across the region and flex against the second object leaving channels between the tines in the region allowing for ventilation.

2. The apparatus of claim 1, wherein, in use, flexing of the tines is substantially constrained to a plane.

3. The apparatus of claim 2, wherein elongate axes of the plurality of tines define the plane.

4. The apparatus of any preceding claim, wherein, in use, each tine of the plurality of tines flexes in a predetermined direction.

5. The apparatus of any preceding claim, wherein the body is arcuate and the tines extend inwardly from the inner circumference of the body, and optionally the body is substantially semi-circular.

6. The apparatus of any preceding claim, wherein the tines are angled acutely with respect to the body.

7. The apparatus of any preceding claim, wherein the plurality of tines comprises tines of different lengths, and/or wherein lengths of the tines increase towards a central region of the body.

8. The apparatus of any preceding claim, wherein one or more tines extending from a region of the body distal from the centre of the body have a length shorter than tines extending from a non-distal region, or wherein one or more tines extending from a region of the body distal from the centre of the body have a length longer than tines extending from a non-distal region.

9. The apparatus of any preceding claim, wherein one or more tines of the plurality of tines comprise portions angled differently with respect to the body from which the one or more tines extend.

10. The apparatus of any preceding claim, wherein the plurality of tines comprises tines angled differently with respect to the body, and/or wherein the angle of the tines with respect to the body increases towards a central region of the body.

11. The apparatus of any preceding claim, wherein the plurality of tines is arranged into at least a first tine group and a second tine group, each tine group comprising a plurality of tines, the tine groups being separated by a tine-free region, and optionally: wherein the separation of the first and second tine groups defined by the tine-free region is at least double the maximum spacing between adjacent tines in the first or second tine groups, and optionally wherein the tine-free region comprises a barrier extending from the body to an extension length at most half the length of the extension length of the tine with the maximum extension length.

12. The apparatus of any of claims 1 to 11, wherein the plurality of tines is arranged into at least a first tine group and a second tine group, each tine group comprising a plurality of tines, the tine groups being separated by a region comprising tines of a length shorter than the minimum tine length of tines in the first or second tine groups.

13. The apparatus of any preceding claim, wherein the body comprises a first body and a second body, each body having a plurality of the tines, and optionally wherein, in use, the first body and second body substantially surround the second object.

14. The apparatus of any preceding claim, wherein a ratio of tine length to spacing between adjacent tines is in the range 2.5 to 20, and/or wherein a thickness of the tines and the body in a direction perpendicular to elongate axes of the plurality of tines is the same.

15. A method for obstructing the passage of debris and providing ventilation through a region between a first object and a second object, the method comprising:
connecting one or more apparatuses according to any of claims 1 to 14 to the first object; and
attaching the first object to the second object to define the region, such that the tines of the one or more apparatuses extend across the region and flex against the second object leaving channels between tines in the region allowing for ventilation.
